# FASCICULE DE BREVET EUROPEEN

(11) **EP 0 656 635 B1**
(45) Date de publication et mention de la délivrance du brevet: **19.04.2000**
(21) Numéro de dépôt: 94402743.2
(22) Date de dépôt: 30.11.1994
(51) Int. Cl.: H01C 7/12, H02H 3/04, G01R 29/02

(54) **Dispositif de mesure d'énergie impulsionnelle**
Vorrichtung zum Messen von Impulsenergie
Device for measuring pulse energy

(30) Priorité: 03.12.1993 FR 9314539
(43) Date de publication de la demande: 07.06.1995
(73) Titulaire: THOMSON-CSF COMMUNICATIONS, 92700 Colombes (FR)
(72) Inventeur: Bourdet, Yves, F-92210 Saint-Cloud (FR); Girard, Christian, F-95360 Montmagny (FR)
(74) Mandataire: Lincot, Georges

(56) Documents cités:
- EP-A- 0 549 432
- FR-A- 2 374 783
- US-A- 3 889 185
- US-A- 4 577 148
- US-A- 5 008 631
- IEEE TRANSACTIONS ON POWER APPARATUS AND SYSTEMS, vol.99, no.5, Septembre 1980, NEW YORK US pages 1879 - 1885 M.C.MULDER ET AL. 'A Microprocessor Based Monitoring and Protection System for a Series capacitor ZnO Nonlinear Bypass Resistor'
- PATENT ABSTRACTS OF JAPAN vol. 14, no. 38 (E-878) 24 Janvier 1990 & JP-A-01 272 074 (TOSHIBA) 31 Octobre 1989
- PATENT ABSTRACTS OF JAPAN vol. 17, no. 473 (E-1423) 27 Août 1993 & JP-A-05 111 147 (MITSUBISHI ELECTRIC) 30 Avril 1993

## Description

La présente invention porte sur un dispositif de mesure d'énergie impulsionnelle, comportant des moyens d'intégration et assurant la mesure de perturbations de fortes intensités écoulées sur un câble. Elle s'applique en particulier à la mesure d'énergie des perturbations, d'origine foudre ou électromagnétique, écoulées sur un câble de terre par des équipements de protection, en vue notamment de la surveillance de ces équipements.

Les équipements de protection contre les perturbations d'origine foudre ou électromagnétique sont en tant que tels connus et de différents types. Ce sont par exemple des paratonnerres ou des circuits ou dispositifs de protection de lignes d'énergie, d'installations ou d'appareillages. Ils sont pourvus d'un câble de retour à la terre du courant dû à chaque perturbation. Ces perturbations sont de fréquence relativement basse, au plus de l'ordre de 1 à 2 MHz. Elles sont de fortes intensités, de valeur maximale variable d'une perturbation à l'autre et pouvant être d'une centaine de kilo ampères.

Pour une fiabilité de la protection assurée par ces équipements, il est utile de disposer d'une information traduisant les sollicitations de chaque équipement de protection, pour permettre de déterminer l'efficacité de l'équipement ou d'estimer son état de fonctionnement à un moment quelconque et sa durée problable de vie et d'assurer la maintenance qui convient.

On connait dans ce but des compteurs d'impulsions foudre, tels que décrit dans la demande FR-A-2 374 783, qui assurent un comptage des perturbations reçues et incrémentent un afficheur d'une unité à chaque nouvelle perturbation reçue. Un tel comptage ne reflète cependant que de manière très imprécice les sollicitations réelles de l'équipement de protection concerné.

La présente invention a pour but de remédier à ce problème, en réalisant une mesure d'énergie des perturbations reçues, en particulier pour connaître avec précision à tout moment les sollicitations réelles d'un équipement de protection contre ces perturbations.

Elle a pour objet un dispositif de mesure d'énergie impulsionnelle, destiné à assurer la mesure de l'énergie de perturbations de fortes intensités écoulées sur un câble, comportant :
- un convertisseur courant-tension, délivrant une tension proportionnelle à l'intensité du courant dans ledit câble,
- une branche de mesure analogique, reliée audit convertisseur courant-tension, et
- un ensemble de traitement et de mémorisation, couplé à ladite branche de mesure et à un afficheur de sortie, caractérisé en ce qu'il comporte au moins deux branches de mesure, comportant chacune un atténuateur d'entrée et un intégrateur de sortie couplé audit atténuateur d'entrée, dans lesquelles les atténuateurs desdites branches ont des atténuations différentes et sont reliés en parallèle audit convertisseur courant-tension.

Ce dispositif présente avantageusement en outre au moins l'une des caractéristiques additionnelles suivantes:
- ledit convertisseur est de rapport de conversion courant-tension inférieur à 1 et est en particulier une sonde de courant montée autour dudit câble et présentant un rapport de conversion de l'ordre de 1/10,
- ledit ensemble de traitement et de mémorisation est un ensemble logique à microprocesseur et mémoire associée,
- le dispositif comporte en outre un circuit d'écrêtage associé à chaque atténuateur, exception faite éventuellement de celui ayant l'atténuation la plus élevée, limitant le niveau de tension de sortie de l'atténuateur concerné pour une protection de l'intégrateur de chaque branche et de l'ensemble de traitement et de mémorisation,
- il comporte en outre sur chaque branche des moyens de détection de valeur de crête, reliés en parallèle avec l'intégrateur de cette branche à l'atténuateur d'entrée de la branche et couplés audit ensemble de traitement et de mémorisation

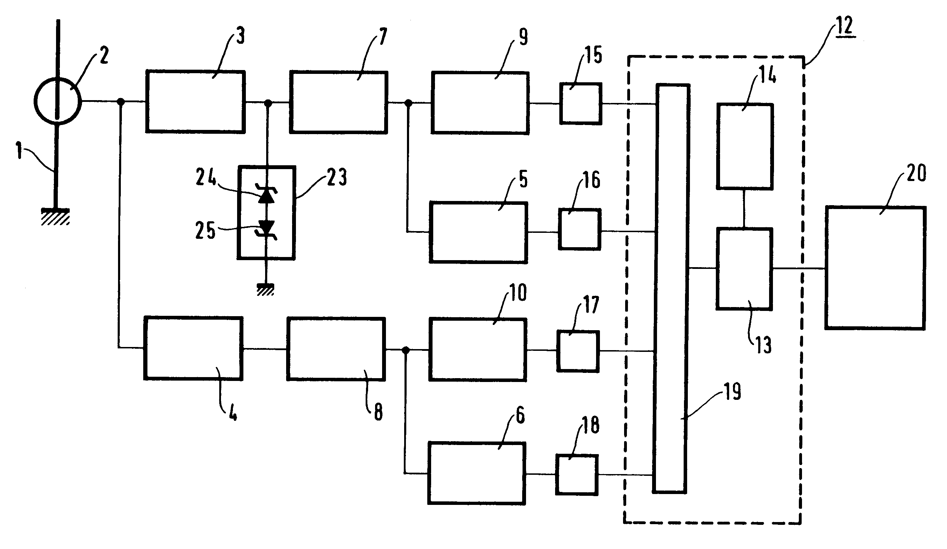

Les caractéristiques et avantages de la présente invention ressortiront de la description faite ci-après d'un exemple de réalisation illustré dans la figure unique du dessin ci-annexé.

Cette figure unique représente sous forme de schéma-bloc un dispositif de mesure d'énergie impulsionnelle, selon l'invention.

Dans cette figure, on a représenté en 1 un câble, sur lequel sont écoulées des perturbations transitoires, d'intensité élevée et variable d'une perturbation à une autre, dont on souhaite mesurer l'énergie. Ce câble 1 est en particulier le câble de terre d'un équipement de protection, par exemple d'une ligne d'énergie, contre les perturbations d'origine foudre ou électromagnétique, qui est en tant que tel connu et non représenté. Il assure le retour à la terre des perturbations successives, reçues et déclenchant l'équipement de protection. L'intensité du courant dans le câble, dû à ces perturbations, est comprise entre 1 kA et 100 kA.

Le dispositif de mesure représenté comporte une sonde de courant 2, montée autour du câble 1, qui est sensible au courant circulant dans le câble et délivre une tension sensiblement proportionnelle à l'intensité de ce courant. Cette sonde est avantageusement choisie pour présenter un rapport de conversion courant-tension inférieur à 1. C'est en particulier une sonde dite de PEARSON, de rapport de conversion égal à 1/10. Dans ces conditions, la tension de sortie de la sonde est comprise entre 100 V et 10 kV, pour l'intensité du courant dans le câble comprise entre 1 kA et 100 kA.

Ce dispositif de mesure comporte en outre deux atténuateurs 3 et 4, d'atténuation différente l'un de l'autre, qui sont tous deux reliés à la sortie de la sonde 2, et deux intégrateurs 5 et 6, qui sont reliés l'un à l'atténuateur 3 à travers un circuit de mise en forme 7 et l'autre à l'atténuateur 4 à travers un autre circuit de mise en forme 8. Avantageusement il comporte aussi deux détecteurs de crête 9 et 10, qui sont également reliés à la sortie des circuits de mise en forme 7 et 8, respectivement.

Les sorties des deux intégrateurs 5 et 6 et des deux détecteurs de crête 9 et 10 sont reliées à un ensemble logique de traitement et de gestion 12. Cet ensemble logique 12 est organisé essentiellement autour d'un microprocesseur 13 et d'une mémoire associée 14. Il comporte, en outre, quatre circuits d'entrée 15 à 18 de conversion analogique-numérique, qui sont reliés aux intégrateurs et aux détecteurs de crête, et un circuit d'interface 19 entre ces circuits d'entrée et le microprocesseur. Il est relié à un afficheur de sortie 20, à travers un circuit d'interface de sortie non représenté appartenant à l'afficheur ou à l'ensemble logique 12.

Les atténuateurs 3 et 4 divisent en deux la gamme des valeurs possibles de la tension de sortie de la sonde 2, pour une plus grande précision de la mesure d'énergie de chaque perturbation écoulée à la terre par le câble 1.

Dans cette réalisation, l'atténuateur 3 réalise une atténuation de 40 dB. Il est suivi d'un circuit d'écrêtage 23, qui limite le niveau du signal de sortie de cet atténuateur à une valeur compatible avec les circuits amont le recevant. Ce circuit d'écrêtage est réalisé par deux diodes Zener 24 et 25, de tension de seuil de coupure à 13,5 V maximum, montées tête-bêche entre la sortie de l'atténuateur 3 et la masse. Il permet l'alimentation des intégrateurs, des détecteurs de crête et de l'ensemble logique par une tension de ±15 V et une bonne protection de ces circuits.

L'atténuateur 4 réalise une atténuation de 60 dB. Il est sans circuit d'écrêtage associé, rendu non nécessaire compte tenu du niveau maximal de son signal de sortie compris entre O,1 V et 10 V.

Ces deux atténuateurs reliés en commun à la sonde 2 définissent à partir de cette sonde deux branches de mesure, en fonction de l'intensité du courant résultant de chaque perturbation incidente écoulée dans le câble 1. Ces deux branches de mesure correspondent aux intensités de 1 à une dizaine de kA sur le câble 1, pour lesquelles la tension de sortie de l'atténuateur 3 après écrêtage est comprise entre 1 et 13,5 V maximum, et aux intensités de 10 à 100 kA sur le câble 1, pour lesquelles la tension de sortie de l'atténuateur 4 est comprise entre 1 et 10 V.

Les mesures réalisées pour les deux intégrateurs se chevauchent l'une l'autre, pour les intensités de courant de 10 kA et légèrement plus sur le câble 1. Ces deux intégrateurs reçoivent simultanément des signaux d'entrée qui présentent entre eux un rapport de 10 mais restent toujours inférieurs à 15 V. L'un ou l'autre de ces deux intégrateurs est en pratique seul retenu pour la mesure de l'énergie de chaque perturbation incidente, en fonction l'intensité du courant sur le câble, par comparaison dans l'ensemble logique des couples de signaux reçus de chaque branche de mesure.

Les circuits de mise en forme assurent un filtrage et un lissage des signaux délivrés par les atténuateurs.

Dans l'ensemble logique 12, le microprocesseur 13 assure la lecture séquentielle des sorties des circuits de conversion analogique-numérique 15 à 18. Il associe par couple les deux signaux numériques de mesure en provenance de chaque branche. Il sélectionne le seul couple représentatif de la perturbation incidente, pour mémoriser ce couple sélectionné et la date à laquelle s'est produite la perturbation et pour les afficher.

L'afficheur permet de visualiser à la demande l'ensemble des perturbations ainsi mémorisées au fur et à mesure dans le temps ou dans une période souhaitée.

L'ensemble logique peut également comptabiliser les perturbations qui se sont produites au fur et à mesure, pour afficher ce nombre.

Ce dispositif a été décrit en regard de l'ensemble de réalisation illustré. Il est évident que les valeurs numériques indiquées au cours de la description ci-avant ont été données à titre d'exemple pour une meilleure compréhension. Il est également évident que le dispositif peut comporter une seule branche de mesure ou un nombre de branches de mesure supérieur à deux, selon la précision de la mesure d'énergie qui est souhaitée.

## Revendications

1. Dispositif de mesure d'énergie impulsionnelle, destiné à assurer la mesure de l'énergie de perturbations de fortes intensités écoulées sur un câble, comportant :
- un convertisseur courant-tension (2), délivrant une tension proportionnelle à l'intensité du courant dans ledit câble,
- une branche de mesure analogique (3, 5, 7, 9), reliée audit convertisseur courant-tension, et
- un ensemble de traitement et de mémorisation (12), couplé à ladite branche de mesure et à un afficheur de sortie,
caractérisé en ce qu'il comporte au moins deux branches de mesure, comportant chacune un atténuateur d'entrée (3, 4) et un intégrateur de sortie (5, 6) couplé audit atténuateur d'entrée, dans lesquelles les atténuateurs desdites branches ont des atténuations différentes et sont reliés en parallèle audit convertisseur courant-tension (2).

2. Dispositif selon la revendication 1, caractérisé en ce que ledit convertisseur (2) présente un rapport de conversion courant-tension inférieur à 1.

3. Dispositif selon la revendication 2, caractérisé en ce que ledit convertisseur (2) est une sonde de courant, montée autour dudit câble (1) et présentant un rapport de conversion de l'ordre de 1/10.

4. Dispositif selon l'une des revendications 1 à 3, caractérisé en ce qu'il comporte en outre un circuit d'écrêtage (23) associé à chaque atténuateur (3, 4), exception faite éventuellement de celui ayant l'atténuation la plus élevée, limitant le niveau de tension de sortie de l'atténuateur concerné, pour une protection de cet intégrateur et de l'ensemble de traitement et de mémorisation.

5. Dispositif selon l'une des revendications 1 à 4, caractérisé en ce qu'il comporte en outre sur chaque branche de mesure des moyens de détection de valeur de crête (9, 10), reliés en parallèle avec ledit intégrateur (5, 6) de cette branche de mesure à l'atténuateur (3, 4) d'entrée de la branche de mesure et couplés audit ensemble de traitement et de mémorisation (12).

## Claims

1. Device for measuring pulse energy, designed to measure the energy of high-intensity disturbances flowing along a cable, comprising:
- a current/voltage converter (2) delivering a voltage proportional to the intensity of the current in the said cable,
- an analogue measurement branch (3, 5, 7, 9), linked to the said current/voltage converter and
- a processing and storage assembly (12), coupled to the said measurement branch and to an output display,
characterized in that it comprises at least two measurement branches, each comprising an input attenuator (3, 4) and an output integrator (5, 6) which is coupled to the said input attenuator, in which branches the attenuators thereof have different attenuations and are linked in parallel to the said current/voltage converter (2).

2. Device according to Claim 1, characterized in that the said converter (2) exhibits a current/voltage conversion ratio of less than 1.

3. Device according to Claim 2, characterized in that the said converter (2) is a current probe, mounted around the said cable (1) and exhibiting a conversion ratio of the order of 1/10.

4. Device according to one of Claims 1 to 3, characterized in that it furthermore comprises a peak-limiting circuit (23) associated with each attenuator (3, 4), with the possible exception of that having the highest attenuation, limiting the output voltage level of the relevant attenuator, for protection of this integrator and of the processing and storage assembly.

5. Device according to one of Claims 1 to 4, characterized in that it furthermore comprises, on each measurement branch, peak value detection means (9, 10), linked in parallel with the said integrator (5, 6) of this measurement branch to the input attenuator (3, 4) of the measurement branch, and coupled to the said processing and storage assembly (12).

## Patentansprüche

1. Vorrichtung zur Messung von Impulsenergie, um die Energie von Störungen großer Stromstärke auf einem Kabel zu messen,
- mit einem Strom-Spannungswandler (2), der eine zur Stromstärke auf dem Kabel proportionale Spannung liefert,
- mit einem analogen Meßzweig (3, 5, 7, 9), der mit dem Strom-Spannungswandler verbunden ist,
- und mit einer Verarbeitungs und Speichereinheit (12), die an den Meßzweig und an ein Anzeigeorgan am Ausgang gekoppelt ist,
dadurch gekennzeichnet, daß sie mindestens zwei Meßzweige mit je einem Dämpfungsglied (3, 4) am Eingang und einem an das Dämpfungsglied gekoppelten Integrierglied am Ausgang aufweist, wobei die Dämpfungsglieder der Zweige unterschiedliche Dämpfungswerte besitzen und parallel an den Strom-Spannungswandler (2) angeschlossen sind.

2. Vorrichtung nach Anspruch 1, dadurch gekennzeichnet, daß der Wandler (2) ein Umwandlungsverhältnis zwischen Strom und Spannung kleiner als 1 besitzt.

3. Vorrichtung nach Anspruch 2, dadurch gekennzeichnet, daß der Wandler (2) eine Strommeßsonde ist, die um das Kabel (1) herum montiert ist und ein Umwandlungsverhältnis von etwa 1:10 besitzt.

4. Vorrichtung nach einem der Ansprüche 1 bis 3, dadurch gekennzeichnet, daß sie weiter eine Begrenzerschaltung (23) in Verbindung mit jedem der Dämpfungsglieder (3, 4), gegebenenfalls ausgenommen das Dämpfungsglied mit dem höchsten Dämpfungswert, besitzt, die den Spannungspegel am Ausgang des betreffenden Dämpfungsglieds begrenzt, um das zugeordnete Integrierglied und die Verarbeitungs- und Speichereinheit zu schützen.

5. Vorrichtung nach einem der Ansprüche 1 bis 4, dadurch gekennzeichnet, daß sie weiter in jedem Meßzweig Mittel (9, 10) zur Erfassung des Spitzenwerts besitzt, die parallel zum Integrierglied (5, 6) dieses Meßzweigs an das pämpfungsglied (3, 4) am Eingang dieses Meßzweigs angeschlossen und an die Verarbeitungs- und Speichereinheit (12) gekoppelt sind.
